**Europäisches Patentamt**

**European Patent Office**

**Office européen des brevets**

(19)

(11) Numéro de publication : **0 149 404**
**B1**

(12) ‾FASCICULE DE BREVET EUROPÉEN‾

(45) Date de publication du fascicule du brevet :
**15.03.89**

(21) Numéro de dépôt : **84402760.7**

(22) Date de dépôt : **28.12.84**

(51) Int. Cl.⁴ : **H 03 L   1/02**

(54) **Oscillateur accordable de grande précision, et radar comportant un tel oscillateur.**

(30) Priorité : **13.01.84 FR 8400501**

(43) Date de publication de la demande :
**24.07.85 Bulletin 85/30**

(45) Mention de la délivrance du brevet :
**15.03.89 Bulletin 89/11**

(84) Etats contractants désignés :
**DE GB**

(56) Documents cités :
**EP--A-- 0 088 669**
**GB--A-- 2 064 248**
**US--A-- 4 243 949**
**US--A-- 4 297 657**

(73) Titulaire : **THOMSON-CSF**
**173, Boulevard Haussmann**
**F-75379 Paris Cédex 08 (FR)**

(72) Inventeur : **Chapelle, Pierre**
**THOMSON-CSF SCPI 173, bld Haussmann**
**F-75379 Paris Cedex 08 (FR)**

(74) Mandataire : **Benoit, Monique et al**
**THOMSON-CSF SCPI 19, avenue de Messine**
**F-75008 Paris (FR)**

EP 0 149 404 B1

## Description

L'invention concerne principalement des oscillateurs accordables de grande précision.

Dans la suite de ce brevet nous appellerons indistinctement « oscillateur » le circuit oscillant numéroté 1 sur les figures 1, 2 et 3 et le dispositif selon l'invention générant un courant électrique de fréquence désirée.

De nombreux dispositifs électriques ou électroniques comportent des oscillateurs accordables. Pour certains de ces dispositifs comme par exemple pour des radars à ondes continues modulées en fréquence (FM-CW en terminologie anglo-saxonne), les performances du dispositif dépendent directement de la précision des fréquences générées par l'oscillateur.

Il est connu d'inclure un oscillateur dans une boucle d'asservissement en fréquence. Tout écart modifie les commandes de l'oscillateur de façon à obtenir la fréquence désirée. Les dispositifs à boucle d'asservissement en fréquence permettent d'obtenir des oscillateurs avec des précisions relatives des fréquences de quelques pour cent.

Le Brevet GB-A-2 064 248 décrit l'utilisation de mémoires électroniques, de convertisseurs analogique-numérique et numérique-analogique et de capteurs de température pour effectuer une compensation en température de la fréquence d'un oscillateur.

De plus, le Brevet US-A-4 297 657 décrit l'utilisation de convertisseurs numérique-analogique dans une boucle d'asservissement.

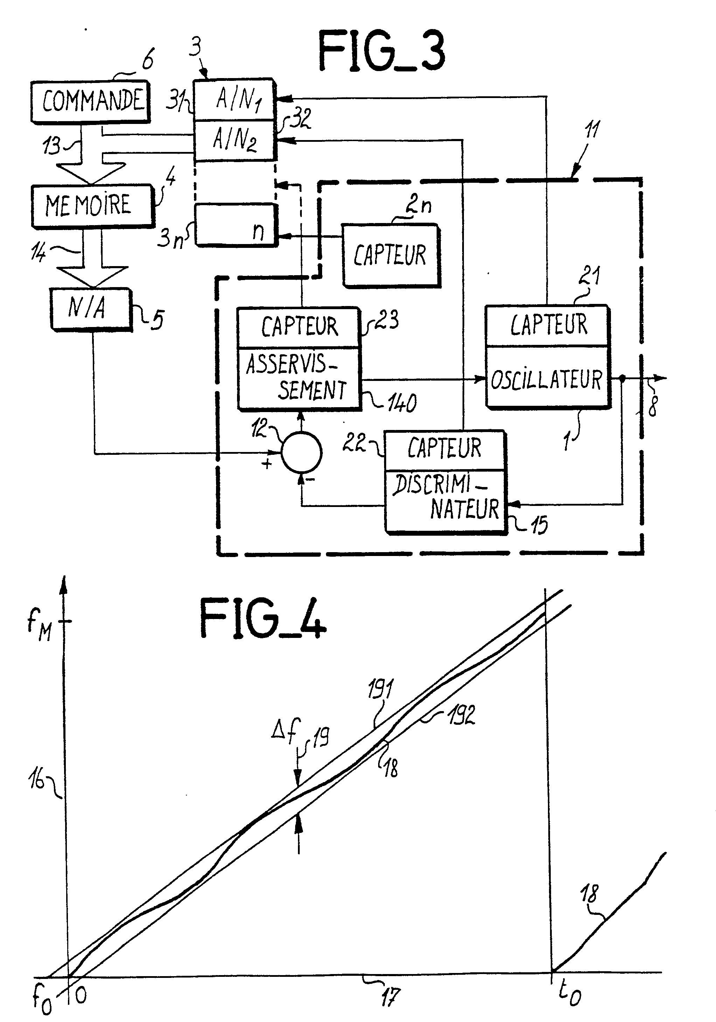

Par contre, dans le dispositif selon la présente invention tel qu'illustré sur la figure 3, le convertisseur numérique-analogique se trouve à l'extérieur de la boucle d'asservissement.

Le dispositif selon la présente invention se propose de stocker dans une mémoire les corrections des commandes à appliquer à un oscillateur ou à une boucle d'asservissement en fréquence comportant un oscillateur, afin d'améliorer la précision en fréquence. Les corrections sont principalement nécessaires par suite d'utilisation de composants non parfaitement linéaires ainsi que par la modification avec la température du comportement des composants utilisés.

L'invention a principalement pour objet un oscillateur accordable en fréquence comportant une mémoire, des convertisseurs analogique-numérique, un convertisseur numérique-analogique, une boucle d'asservissement en fréquence de l'oscillateur et au moins un capteur de température disposé sur le circuit de la boucle d'asservissement en fréquence, caractérisé par le fait que chaque capteur de température est relié à son convertisseur analogique-numérique, les convertisseurs analogique-numérique sont reliés à la mémoire, la mémoire est reliée à la boucle d'asservissement de façon à ce que la mémoire, les convertisseurs analogique-numérique et le convertisseur numérique-analogique n'étant pas placés dans la boucle d'asservissement sont susceptibles de travailler à des fréquences inférieures à la fréquence de travail de la boucle d'asservissement en fréquence.

L'invention sera mieux comprise au moyen de la description ci-après et des figures annexées données comme des exemples non limitatifs parmi lesquels :
- la figure 1, est une vue d'une première variante de réalisation d'un dispositif de compensation de température ;
- la figure 2, est une vue d'une seconde variante de réalisation d'un dispositif de compensation de température ;
- la figure 3, est une variante de réalisation du dispositif selon l'invention ;
- la figure 4, illustre les performances obtenues par le dispositif de la figure 3.

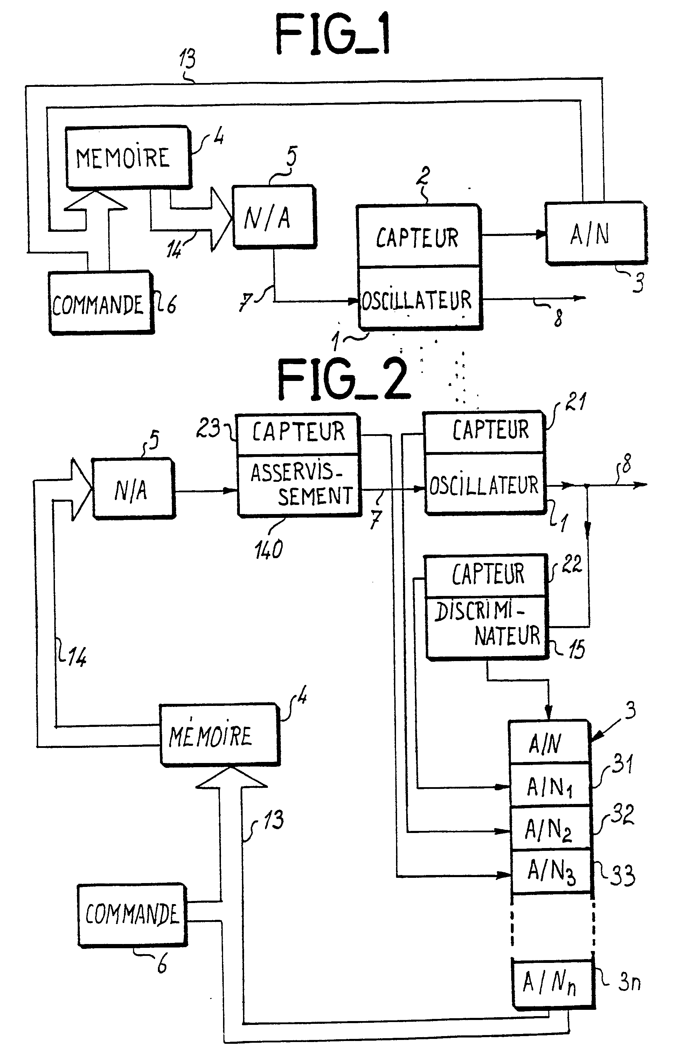

Sur les figures 1 à 4 les mêmes références désignent les mêmes éléments.

Dans l'exemple décrit, un oscillateur fournit une fréquence f fonction de la tension de commande appliquée. L'application du dispositif selon l'invention à d'autres types d'oscillateurs ne sort pas du cadre de la présente invention.

Sur la figure 1, on peut voir un dispositif ne comportant pas de boucle d'asservissement en fréquence. Le dispositif comporte un oscillateur 1, qui a une tension électrique v appliquée en son entrée 7, fournit à sa sortie 8 une fréquence f égale à $g(v, \theta)$ ; $\theta$ étant la température à laquelle est porté l'oscillateur 1, g est une fonction monotone quasi linéaire de v. Le dispositif se propose de corriger les non-linéarités de g et/ou ses variations avec la température $\theta$. Avantageusement sur l'oscillateur 1 est disposé un capteur de température 2 relié à un convertisseur analogique numérique 3 ; la valeur numérisée de la température de l'oscillateur 1 ainsi qu'une valeur de commande numérique générée par un dispositif de commande 6 sont transmises par un bus d'adresse 13 d'une mémoire 4. A cette adresse est stockée dans la mémoire 4 une valeur u correspondant à la tension appliquée à l'oscillateur 1 compte tenu des paramètres pris en compte pour obtenir la fréquence désirée. La donnée u lue en mémoire 4 est transmise à un convertisseur numérique-analogique par un bus de donnée 14. Le convertisseur numérique-analogique convertit la donnée u lue en mémoire 4 en une tension de commande de l'oscillateur 1. La mémoire 4 est avantageusement du type mémoire morte programmable (PROM en terminologie anglo-saxonne). A chaque valeur du couple $(u, \theta)$ correspond dans la mémoire 4 une valeur numérique de la tension à appliquer en 7 à l'oscillateur 1 pour obtenir la fréquence désirée.

Sur la figure 2, on peut voir un dispositif appliqué à un oscillateur inclus dans une boucle d'asservissement en fréquence. Une électronique d'asservissement 140 fournit à l'entrée 7 de l'oscillateur la fonction de transfert permettant la génération d'une fréquence à la sortie 8 de l'oscillateur 1. L'électronique d'asservissement est par exem-

ple un circuit intégrateur. Un discriminateur 15 transforme la fréquence f en une tension. Le discriminateur 15 est par exemple du type à ligne à retard. Un signal d'entrée du type cos (ft) passe parallèlement, directement et par une ligne à retard et arrive dans un multiplicateur. Le signal à la sortie du multiplicateur est du type cos (ft) cos (f (t-τ)), τ étant le retard généré par la ligne à retard. Le signal passe par un filtre passe-bas et est approximativement égal à cos (fτ). En se plaçant dans le domaine de linéarité du discriminateur 15 on a cos (fτ) fτ. fτ est donc une tension électrique proportionnelle à la fréquence f. Un convertisseur analogique-numérique 3 numérise la tension de sortie du discriminateur 15. Des capteurs de température 21, 22, 23 sont placés respectivement sur l'oscillateur 1, sur le discriminateur 15, sur l'électronique d'asservissement 140. Les tensions électriques correspondant aux températures mesurées en ces divers points sont numérisées par des convertisseurs analogiques numériques respectivement 31, 32, 33. D'autres réalisations peuvent comporter un nombre différent de capteurs le température et de convertisseurs analogiques associés. Les convertisseurs analogiques-numériques 3 ainsi que l'électronique de commande 6 sont reliés par un bus d'adresse 13 à une mémoire 4. La mémoire 4 est reliée par un bus de donnée 14 à un convertisseur numérique-analogique 5. Le convertisseur numérique-analogique 5 est relié à l'électronique d'asservissement 140.

La présence de la mémoire 4 permet de corriger les écarts de linéarités de l'électronique d'asservissement 140, de l'oscillateur 1 et du discriminateur 15 ainsi que les variations de leur comportement avec la température. En mémoire 4, aux adresses correspondant à la commande numérisée, la valeur numérisée de la tension correspondant à la fréquence de sortie 8 de l'oscillateur 1 et aux valeurs numérisées des tensions correspondant aux températures en divers points du dispositif est stockée la valeur numérique de la tension à appliquer à l'oscillateur 7 pour générer une fréquence désirée.

Sur la figure 3, on peut voir un dispositif selon l'invention plus particulièrement destiné a des oscillateurs capables de faire varier rapidement la fréquence générée, ainsi qu'aux oscillateurs hyperfréquence. Dans un tel cas il s'avère très difficile d'inclure des convertisseurs analogique-numérique et numérique-analogique dans une boucle d'asservissement de fréquence. En effet on est limité par le temps de réponse de ces dispositifs. De plus, le convertisseur numérique-analogique 5 doit introduire le moins possible de distorsion de numérisation. Le fait de travailler à des fréquences inférieures, en dehors de la boucle d'asservissement en fréquence 11, permet d'obtenir un plus grand choix de circuits convertisseurs numérique-analogique parmi les circuits commercialisés. La boucle d'asservissement en fréquence 11 comporte une électronique d'asservissement 140 connectée à l'entrée de l'oscillateur 1. A la sortie 8 de l'oscillateur 1 est connecté un discriminateur de fréquence 15. Le discriminateur de fréquence 15 est connecté à un additionneur 12. Des capteurs de température 21 à 2n sont disposés sur le circuit de la boucle d'asservissement en fréquence 11. Ces capteurs de température sont connectés à des convertisseurs analogique-numérique 3. Les convertisseurs analogique-numérique 3 ainsi qu'un dispositif de commande 6 sont connectés par le bus d'adresse 13 à une mémoire 4 ; la mémoire 4 est connectée par le bus de donnée 14 à un convertisseur numérique-analogique 5 ; le convertisseur numérique-analogique 5 est connecté a l'additionneur 12 ; l'additionneur 12 est connecté à l'électronique d'asservissement 140. L'additionneur 12 soustrait à la tension appliquée la correction de tension nécessaire pour obtenir la fréquence désirée à la sortie 8 de l'oscillateur 1. En mémoire 4, à l'adresse correspondant aux valeurs numérisées des températures en divers points du circuit de la boucle d'asservissement en fréquence 11 et à la tension de commande délivrée à un dispositif de commande 6 est stockée la valeur numérisée de la tension de commande nécessaire pour obtenir la fréquence désirée. Cette valeur est convertie par le convertisseur numérique-analogique en une tension à laquelle on ajoute les corrections apportées par le discriminateur de fréquence 15 dans l'additionneur 12.

Le dispositif de la figure 3 est particulièrement bien adapté aux radars à ondes continues modulées en fréquence. De tels radars nécessitent un courant électrique dont la fréquence sur chaque période augmente linéairement avec le temps. Les performances d'un tel radar sont directement dépendantes de la précision de la linéarité de la fréquence avec le temps. Pour de tels dispositifs la commande 6 est avantageusement un compteur associé à une horloge. Dans une variante de réalisation le dispositif de commande 6 comporte un générateur de tension variant linéairement avec le temps ainsi qu'un convertisseur analogique-numérique.

Sur la figure 4, on peut voir les variations de fréquence en fonction du temps du dispositif de la figure 3. En abscisse 17 est porté le temps t, en ordonnée 16 est portée la fréquence f. Les variations de la fréquence en fonction du temps sont portées sur la courbe 18. Cette courbe est comprise entre deux droites 191 et 192. La différence de fréquence entre les droites 191 et 192, égale à Δf, correspond aux écarts maximaux de la fréquence réelle du dispositif de la figure 3 par rapport à la fréquence désirée. La fréquence obtenue à la sortie 8 de l'oscillateur varie entre le temps $t = 0$ et $t_0$ de façon quasi linéaire entre une fréquence $f_0$ minimale et une fréquence $f_M$ maximale. La précision du dispositif de la figure 3 : $\Delta f / f_M - f_0$ est approximativement égale à 2 à 3 x $10^{-4}$.

Le dispositif objet de la présente invention permet une fabrication entièrement automatique et ne nécessite aucun réglage.

Les composants analogiques du dispositif objet de la présente invention ont été réduits au minimum ce qui permet de diminuer les dimensions et le coût particulièrement sensible dans le cas d'un oscillateur et discriminateur hyperfréquence.

Dans une première réalisation de l'invention on stocke dans la mémoire 4 les valeurs communes à une série d'oscillateurs et discriminateurs, ce qui permet de minimiser le coût de revient.

Dans une deuxième réalisation de l'invention on stocke dans la mémoire 4, afin d'augmenter encore la précision, les valeurs nécessaires au fonctionnement d'un oscillateur et d'un discriminateur individualisés associés a cette mémoire 4.

L'invention s'applique principalement aux oscillateurs commandables en fréquence.

## Revendications

1. Oscillateur accordable en fréquence comportant une mémoire (4), des convertisseurs analogique-numérique (3), un convertisseur numérique-analogique (5), une boucle d'asservissement (11) en fréquence de l'oscillateur et au moins un capteur de température (2) disposé sur le circuit de la boucle d'asservissement (11) en fréquence, caractérisé par le fait que chaque capteur de température est relié à son convertisseur analogique-numérique (3), les convertisseurs analogique-numérique (3) sont reliés à la mémoire (4), la mémoire (4) est reliée à la boucle d'asservissement (11) de façon à ce que la mémoire (4), les convertisseurs analogique-numérique (3) et le convertisseur numérique-analogique (5) n'étant pas placés dans la boucle d'asservissement (11) sont susceptibles de travailler à des fréquences inférieures à la fréquence de travail de la boucle d'asservissement en fréquence (11).

2. Oscillateur selon la revendication 1, caractérisé par le fait que les valeurs stockées dans la mémoire (4) sont propres au circuit oscillateur (1) qui lui est associé.

3. Oscillateur selon l'une quelconque des revendications précédentes, caractérisé par le fait que c'est un oscillateur hyperfréquence.

4. Oscillateur selon l'une quelconque des revendications précédentes, caractérisé par le fait que la mémoire (4) est du type mémoire morte programmable (PROM).

5. Utilisation d'un oscillateur selon l'une quelconque des revendications précédentes dans un dispositif radar.

6. Utilisation d'un oscillateur selon l'une quelconque des revendications 1 à 4, dans un dispositif radar du type à onde continue modulée en fréquence (FM-CW).

## Claims

1. A frequency-tuned oscillator comprising a storage (4), analog-to-digital converters (3), a digital-to-analog converter (5), a frequency control loop (11) for the oscillator, and at least one temperatur probe (2) disposed on the frequency control loop circuit (11), characterized in that each of the temperature probes is connected to its analog-to-digital converter (3), that the analog-to-digital converters (3) are connected to the storage (4), that the storage (4) is connected to the frequency control loop (11), in such a way that the storage (4), the analog-to-digital converters (3) and the digital-to-analog converter (5), which are not placed on the control loop (11), are susceptible of operating at frequencies below the operational frequency of the frequency control loop (11).

2. An oscillator according to claim 1, characterized in that the values memorized in the storage (4) are the proper values of the oscillator loop (1) associated to the storage.

3. An oscillator according to any one of the preceding claims, characterized in that it is a microwave oscillator.

4. An oscillator according to any one of the preceding claims, characterized in that the storage (4) is of the programmable read-only memory type (PROM).

5. The use of an oscillator according to any one of the preceding claims in a radar device.

6. The use of an oscillator according to any one of claims 1 to 4 incorporated in a radar device of the frequency-modulated continuous wave type (FM-CW).

## Patentansprüche

1. Frequenzabstimmbarer Oszillator mit einem Speicher (4), Analog-Digital-Wandlern (3), einem Digital-Analog-Wandler (5), einer Frequenzregelschleife (11) fur den Oszillator, und mindestens einem Temperaturaufnehmer (2), der auf dem Kreis der Frequenzregelschleife (11) angebracht ist, dadurch gekennzeichnet, daß jeder Temperaturaufnehmer an seinen Analog-Digitalumwandler (3) angeschlossen ist, daß die Analog-Digital-Wandler (3) an den Speicher (4) und der Speicher (4) an die Regelschleife (11) angeschlossen sind, derart, daß der Speicher (4), die Analog-Digital-Wandler (3) und der Digital-Analog-Wandler (5), die nicht in der Regelschleife (11) liegen, zum Arbeiten mit niedrigeren Frequenzen als der Betriebsfrequenz der Frequenzregelschleife (11) geeignet sind.

2. Oszillator nach Anspruch 1, dadurch gekennzeichnet, daß die im Speicher (4) gespeicherten Werte zu demjenigen Oszillatorkreis (1) gehören, der ihm zugeordnet ist.

3. Oszillator nach einem der vorhergehenden Anspruche, dadurch gekennzeichnet, daß er ein Mikrowellenoszillator ist.

4. Oszillator nach einem der vorhergehenden Anspruche, dadurch gekennzeichnet, daß der Speicher ein programmierbarer Festspeicher (PROM) ist.

5. Verwendung eines Oszillators nach einem der vorhergehenden Ansprüche in einer Radareinrichtung.

6. Verwendung eines Oszillators nach einem der Ansprüche 1 bis 4 in einer Radareinrichtung mit frequenzmodulierter Dauerstrichwelle (FM-CW).

# FIG_1

# FIG_2

# FIG_3

# FIG_4